# EUROPEAN PATENT APPLICATION

(11) **EP 4 439 679 A1**
(43) Date of publication of application: **02.10.2024**
(21) Application number: 22899107.1
(22) Date of filing: 25.11.2022
(51) Int. Cl.: H01L 29/786, H01L 21/02

(54) **OXIDE SEMICONDUCTOR, MANUFACTURING METHOD THEREFOR, AND SEMICONDUCTOR DEVICE COMPRISING SAME**

(30) Priority: 26.11.2021 KR 20210166178
(71) Applicant: Korea Institute of Ceramic Engineering and Technology, Jinju-si, Gyeongsangnam-do 52851 (KR); IUCF-HYU (INDUSTRY-UNIVERSITY COOPERATION FOUNDATION HANYANG UNIVERSITY), Seoul 04763 (KR)
(72) Inventor: HEO, Soo Won, Jinju-si, Gyeongsangnam-do 52851 (KR); YOON, Young Joon, Jinju-si, Gyeongsangnam-do 52851 (KR); CHO, Sung Beom, Jinju-si, Gyeongsangnam-do 52851 (KR); PARK, In Pyo, Jinju-si, Gyeongsangnam-do 52851 (KR); KIM, Hyeon Woo, Jinju-si, Gyeongsangnam-do 52851 (KR); PARK, Jin Seong, Seoul 04763 (KR); KIM, Hye Mi, Seoul 04763 (KR); JUNG, Hyunsung, Jinju-si, Gyeongsangnam-do 52851 (KR); HWANG, Bukyeong, Jinju-si, Gyeongsangnam-do 52851 (KR)
(74) Representative: Dehns
(86) International application number: PCT/KR2022/018899
(87) International publication number: WO 2023/096425

(57) **Abstract**

An Al-Sb-O-based oxide semiconductor containing aluminum (Al) and antimony (Sb) has excellent electrical conductivity and band gap, such that the semiconductor can be applied to thin film transistors and the like.

## Description

### Technical Field

The present invention relates to an oxide semiconductor, to a method for manufacturing the same, and to a semiconductor device comprising the same.

### Background Art

An oxide semiconductor is a semiconductor material in which its conductivity is controlled, and its band gap is adjusted, through doping of oxide materials such as zinc oxide, cadmium oxide, and indium oxide. It is in general a transparent semiconductor material with a wide band gap.

Since oxide semiconductors have a wide band gap and cannot absorb low-energy visible light or infrared light, they have the property of transmitting light in the range of visible light (360 to 800 nm). Oxide semiconductors have recently become very important materials in the field of transparent semiconductors by virtue of their excellent optical and electrical properties. They are semiconductor materials with high potential for applications in various industrial fields such as transparent displays, transparent sensors, and transparent solar cells.

For example, oxide materials such as zinc oxide are semiconductor materials that can control the conductivity through doping or control the band gap through alloying. The key feature of these oxide semiconductors lies in a wide band gap, and they have very high light transmittance in the region of visible light, making them transparent.

Professor Hideo Hosono of Tokyo Institute of Technology, Japan, disclosed indium gallium zinc oxide (IGZO), a transparent semiconductor with high charge mobility, and a thin film transistor using it in Korean Patent No. 0939998. IGZO is an oxide material composed of indium, gallium, zinc, and oxygen. It is a semiconductor material with a wide band gap of 3 eV or more. IGZO as an oxide semiconductor can be used to manufacture thin film transistors; thus, it is already being used as a backplane panel device in the display field. When thin film transistors are manufactured using IGZO, the charge mobility is superior to that of amorphous silicon thin film transistors; thus, they are used as backplane circuits and switching devices in the display field.

### [Prior art documents]

### (Patent Document 1) Korean Patent No. 0939998 (January 26, 2010)

### Disclosure of Invention

### Technical Problem

In order to find new materials to replace IGZO, which is currently used as an oxide semiconductor, the present inventors have secured an area that can be researched from big data of oxides through data mining, analyzed physical properties such as electrical conductivity and band gap related to thin film transistors (TFTs), and filtered candidates through data screening, thereby obtaining potential element combinations.

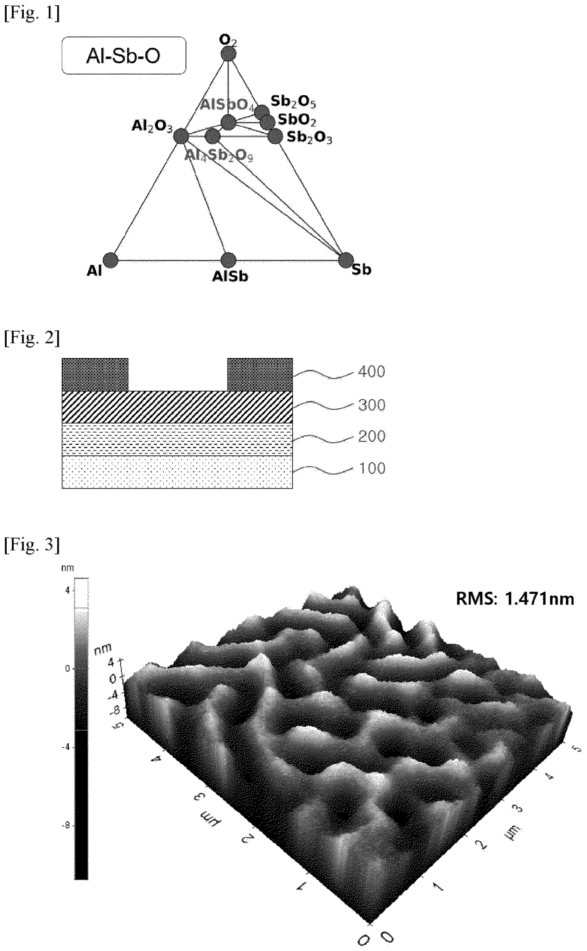

The present inventors also created a database of their structures and secured a list of materials with a high possibility of crystallization through phase equilibrium diagrams (see Fig. 1). As a result of analyzing physical properties such as electrical conductivity and band gap through machine learning techniques, oxides containing aluminum (Al) and antimony (Sb) have been finally determined as materials to replace IGZO.

Accordingly, an object of the present invention is to provide a new oxide semiconductor with excellent electrical conductivity and band gap that can be applied to thin film transistors and a method for manufacturing the same. In addition, another object of the present invention is to provide a semiconductor device, a thin film transistor, and a display device using the oxide semiconductor.

### Solution to Problem

The present invention provides an oxide semiconductor that comprises an oxide containing aluminum (Al) and antimony (Sb).

In addition, the present invention provides a method for manufacturing the oxide semiconductor that comprises mixing a first precursor solution containing an aluminum precursor and a second precursor solution containing an antimony precursor to prepare a sol-gel solution; and coating the sol-gel solution on a substrate to form an oxide semiconductor thin film.

In addition, the present invention provides a method for manufacturing the oxide semiconductor that comprises sputtering-depositing an aluminum precursor and an antimony precursor on a substrate to form an oxide semiconductor thin film containing aluminum and antimony.

In addition, the present invention provides a semiconductor device that comprises a substrate, a dielectric layer formed on the substrate, a semiconductor layer comprising the oxide semiconductor formed on the dielectric layer, and an electrode formed on the semiconductor layer.

In addition, the present invention provides a thin film transistor that comprises the semiconductor device.

In addition, the present invention provides a display device that comprises the thin film transistor.

### Advantageous Effects of Invention

The Al-Sb-O-based oxide semiconductor according to the present invention has excellent electrical conductivity and band gap, so that it can be applied to semiconductor devices such as thin film transistors. Such an Al-Sb-O-based oxide semiconductor device can be provided in a display device to enhance performance.

### Brief Description of Drawings

Fig. 1 is a phase equilibrium diagram of an Al-Sb-O-based oxide semiconductor according to an embodiment.
Fig. 2 is a cross-sectional view of a device comprising an oxide semiconductor according to an embodiment (100: substrate, 200: dielectric layer, 300: semiconductor layer, 400: electrode layer).
Fig. 3 is an example of an AFM image of the surface of an oxide semiconductor thin film.
Figs. 4a to 5c show the test results of oxide semiconductor devices manufactured by a solution process with various Al:Sb molar ratios.
Figs. 6a to 7d show the test results of oxide semiconductor devices thermally treated under various conditions after the solution process.
Figs. 8a to 8d show the test results of oxide semiconductor devices manufactured with various thin film thicknesses through a solution process.
Figs. 9a to 9d show the test results of oxide semiconductor devices manufactured through a solution process using various additives.
Fig. 10 shows the TG-DTA analysis results of an oxide semiconductor according to an embodiment.
Fig. 11 shows the XRD analysis results of an oxide semiconductor according to an embodiment.
Fig. 12 shows the XPS analysis results of an oxide semiconductor according to an embodiment.
Figs. 13a to 13e show the test results of oxide semiconductor devices manufactured by a deposition process with various Al:Sb molar ratios.
Figs. 14a to 14c show the test results of oxide semiconductor devices manufactured by a deposition process with various partial pressure ratios of Ar:O₂.
Figs. 15a to 15d show the test results of oxide semiconductor devices thermally treated at various temperatures after the deposition process.
Figs. 16a to 16c show the test results of oxide semiconductor devices manufactured with various thin film thicknesses through a deposition process.

### Best Mode for Carrying out the Invention

Hereinafter, various embodiments and examples of the present invention will be described in detail with reference to the drawings.

In describing the present invention, if it is determined that a detailed description of a related known constitution or function may obscure the gist of the present invention, the detailed description will be omitted. In addition, for the sake of description, the sizes of individual elements in the appended drawings may be exaggeratedly depicted or omitted, and they may differ from the actual sizes.

In the present specification, in the case where an element is mentioned to be formed, connected, or combined on or under another element, it means all of the cases where one element is directly, or indirectly through another element, formed, connected, or combined with another element. In addition, it should be understood that the criterion for the terms on and under of each component may vary depending on the direction in which the object is observed.

In this specification, terms referring to the respective components are used to distinguish them from each other and are not intended to limit the scope of the present invention. In addition, in the present specification, a singular expression is interpreted to cover a plural number as well unless otherwise specified in the context.

In the present specification, the term "comprising" is intended to specify a particular characteristic, region, step, process, element, and/or component. It does not exclude the presence or addition of any other characteristic, region, step, process, element and/or component, unless specifically stated to the contrary.

In the present specification, the terms first, second, and the like are used to describe various components. But the components should not be limited by the terms. The terms are used for the purpose of distinguishing one element from another.

### Oxide semiconductor

The oxide semiconductor according to the present invention comprises an oxide containing aluminum (Al) and antimony (Sb).

As an embodiment, the oxide semiconductor according to the present invention may be composed of an oxide containing aluminum (Al) and antimony (Sb). That is, the oxide semiconductor according to the present invention may be composed only of aluminum (Al), antimony (Sb), and oxygen (O).

The content of the oxide containing aluminum (Al) and antimony (Sb) may be 50% by weight or more, 70% by weight or more, 80% by weight or more, 90% by weight or more, 95% by weight or more, 97% by weight or more, 99% by weight or more, 99.5% by weight or more, 99.9% by weight or more, or 100% by weight, based on the total weight of the oxide semiconductor of the present invention.

In the oxide semiconductor according to the present invention, the molar ratio between aluminum (Al) and antimony (Sb) is preferably adjusted to a specific range.

As an embodiment, the molar ratio of aluminum (Al) and antimony (Sb) in the oxide may be 10:1 to 1:10.

For example, the molar ratio of aluminum (Al) and antimony (Sb) in the oxide may be 10:1 to 1:10, 10:1 to 1:8, 10:1 to 1:6, 10:1 to 1:4, 10:1 to 1:2, 10:1 to 1:1, 8:1 to 1:10, 6:1 to 1:10, 4:1 to 1:10, 2:1 to 1:10, 1:1 to 1:10, 8:1 to 1:8, 6:1 to 1:6, 4:1 to 1:4, 3:1 to 1:3, 2:1 to 1:2, 1.5:1 to 1:1.5, or about 1:1.

In addition, the molar ratio of aluminum (Al), antimony (Sb), and oxygen (O) in the oxide may be adjusted to a specific range.

In an embodiment, the oxide is represented by the following Formula 1.

[Formula 1] AlₓSb_{y}O_{z}

Here, 1 ≤ x ≤ 8, 1 ≤ y ≤ 8, and 1 ≤ z ≤ 15.

In Formula 1, x may be, for example, 1 or more, 2 or more, 3 or more, or 4 or more, and may be 8 or less, 7 or less, 6 or less, 5 or less, 4 or less, 3 or less, or 2 or less, specifically, 1 to 8, 1 to 6, 1 to 4, 1 to 3, 1 to 2, 2 to 8, 3 to 8, 4 to 8, or 2 to 6.

In Formula 1, y may be, for example, 1 or more, 2 or more, 3 or more, or 4 or more, and may be 8 or less, 7 or less, 6 or less, 5 or less, 4 or less, 3 or less, or 2 or less, specifically, 1 to 8, 1 to 6, 1 to 4, 1 to 3, 1 to 2, 2 to 8, 3 to 8, 4 to 8, or 2 to 6.

In Formula 1, z may be, for example, 1 or more, 2 or more, 3 or more, 4 or more, 5 or more, 6 or more, 7 or more, or 8 or more, and may be 15 or less, 14 or less, 13 or less, 12 or less, 11 or less, 10 or less, 9 or less, or 8 or less, specifically, 1 to 15, 1 to 13, 1 to 11, 1 to 10, 1 to 9, 1 to 8, 1 to 6, 1 to 5, 3 to 15, 5 to 15, 7 to 15, 8 to 15, 10 to 15, or 12 to 15.

In addition, x, y, and z may be integers within the ranges exemplified above.

Specifically, in Formula 1, x may be 1 or 2, y may be 1 or 2, and z may be an integer of 3 to 5. More specifically, in Formula 1, x may be 1, y may be 1, and z may be 4.

In addition, in Formula 1, x, y, and z may be determined within a range that satisfies the balance in view of the oxidation number or valency of metal atoms (Al, Sb) and oxygen atoms (O). Specifically, since Al is +3 valent, Sb is +3 or +5 valent, and O is -2 valent, x, y, and z values may be limited in order to satisfy the valence balance of the chemical formula in which these atoms are combined. For example, in Formula 1, when Sb is +5 valent, the chemical formula that satisfies the valence balance may include AlSbO₄; when Sb is +3 valent, the chemical formula that satisfies the valence balance may include AlSbO₃. However, in addition, as long as the valence balance is satisfied, various chemical formulae are possible depending on the molar ratio of the constituent atoms (Al, Sb, and O).

Specifically, the oxide of Formula 1 may be at least one selected from the group consisting of AlSbO₄, AlSbO₃, Al₄Sb₂O₉, A1₂Sb₄O₁₃, Al₄Sb₂O₁₁, and Al₂Sb₄O₉, but it is not limited thereto.

In addition, the oxide semiconductor according to the present invention may further comprise additional components other than the oxide containing aluminum (Al) and antimony (Sb). The additional component may be, for example, aluminum oxide, antimony oxide, or other oxides.

In an embodiment, the oxide semiconductor may have crystallinity. Specifically, it may have one or more crystalline peaks in an X-ray diffraction (XRD) spectrum. In another embodiment, the oxide semiconductor may have amorphousness. Specifically, it may have no crystalline peak appearing in an X-ray diffraction (XRD) spectrum.

The oxide semiconductor may have a surface roughness within a specific range when manufactured as a thin film (see Fig. 3). For example, the RMS roughness (Rq) may be 0.5 nm or more, 0.7 nm or more, 1 nm or more, 1.2 nm or more, or 1.4 nm or more, and may be 3 nm or less, 2.5 nm or less, 2 nm or less, 1.7 nm or less, or 1.5 nm or less, as a specific example, 1 nm to 2 nm.

The oxide semiconductor according to the present invention has electrical conductivity and band gap applicable to thin film transistors or the like.

For example, the oxide semiconductor according to the present invention may have n-type characteristics.

The n-type electrical conductivity of the oxide semiconductor may be 50 1/fQ/m/s or more, 70 1/fQ/m/s or more, 80 1/fQ/m/s or more, 90 1/fQ/m/s or more, 95 1/fQ/m/s or more, 97 1/fQ/m/s or more, 98 1/fQ/m/s or more, or 99 1/fQ/m/s or more. In addition, the n-type electrical conductivity of the oxide semiconductor may be 300 1/fQ/m/s or less, 200 1/fQ/m/s or less, or 120 1/fQ/m/s or less. As a specific example, the n-type electrical conductivity of the oxide semiconductor may be 80 1/fQ/m/s to 120 1/fQ/m/s.

In addition, the oxide semiconductor according to the present invention may have p-type characteristics depending on the composition.

The p-type electrical conductivity of the oxide semiconductor may be 5 1/fQ/m/s or more, 10 1/fQ/m/s or more, 15 1/fQ/m/s or more, or 20 1/fQ/m/s or more. In addition, the p-type electrical conductivity of the oxide semiconductor may be 100 1/fQ/m/s or less, 70 1/fQ/m/s or less, 50 1/fQ/m/s or less, or 30 1/fQ/m/s or less. As a specific example, the p-type electrical conductivity of the oxide semiconductor may be 10 1/fQ/m/s to 50 1/fQ/m/s.

The electrical conductivity may be calculated using the first-principles calculations and Boltzmann transport equation and the Hall effect measurement.

The band gap of the oxide semiconductor may be 1 eV or more, 1.2 eV or more, 1.3 eV or more, 1.4 eV or more, 1.5 eV or more, or 1.6 eV or more. In addition, the band gap of the oxide semiconductor may be 3 eV or less, 2.5 eV or less, 2 eV or less, or 1.8 eV or less. As a specific example, the band gap of the oxide semiconductor may be 1.5 eV to 2 eV. The band gap may be measured by, for example, measuring the absorbance of a sample with a UV-visible spectrometer and drawing a Tauc plot to calculate the optical band gap.

In an embodiment, the oxide semiconductor may have an n-type electrical conductivity of 80 1/fQ/m/s or more and a measured band gap of 1.5 eV or more.

Accordingly, a semiconductor device, for example, a thin film transistor (TFT), comprising the oxide semiconductor according to the present invention may have excellent performance.

The field effect mobility (µ_{FE}) of the Al-Sb-O-based oxide semiconductor device may be, for example, 0.001 cm²/Vs or more, 0.01 cm²/Vs or more, 0.1 cm²/Vs or more, 0.2 cm²/Vs or more, 0.3 cm²/Vs or more, 0.4 cm²/Vs or more, or 0.5 cm²/Vs or more, and 10 cm²/Vs or less, 7 cm²/Vs or less, 5 cm²/Vs or less, 3 cm²/Vs or less, 2 cm²/Vs or less, 1 cm²/Vs or less, 0.9 cm²/Vs or less, 0.8 cm²/Vs or less, 0.7 cm²/Vs or less, or 0.6 cm²/Vs or less. As a specific example, the field effect mobility (µ_{FE}) of the Al-Sb-O-based oxide semiconductor device may be 0.01 cm²/Vs to 10 cm²/Vs, 0.1 cm²/Vs to 10 cm²/Vs, 0.01 cm²/Vs to 1 cm²/Vs, or 0.1 cm²/Vs to 5 cm²/Vs.

The on/off ratio of the Al-Sb-O-based oxide semiconductor device may be, for example, 1.0×10² or more, 1.0×10³ or more, 1.0×10⁴ or more, 3.0×10⁴ or more, 5.0×10⁴ or more, 7.0×10⁴ or more, or 9.0×10⁴ or more, and 1.0×10⁷ or less, 5.0×10⁶ or less, 3.0×10⁶ or less, 1.0×10⁶ or less, 5.0×10⁵ or less, 3.0×10⁵ or less, or 1.0×10⁵ or less. As a specific example, the on/off ratio of the Al-Sb-O-based oxide semiconductor device may be 1.0×10² to 1.0×10⁷, 1.0×10² to 1.0×10⁵, 1.0×10³ to 1.0×10⁷, or 1.0×10³ to 1.0×10⁵.

The threshold voltage (Vₜₕ) of the Al-Sb-O-based oxide semiconductor device may be, for example, -40 V or more, -30 V or more, -20 V or more, -10 V or more, 0 V or more, +3 V or more, +5 V or more, or +7 V or more, and +40 V or less, +30 V or less, +20 V or less, or +10 V or less. As a specific example, the threshold voltage (Vₜₕ) of the Al-Sb-O-based oxide semiconductor device may be -40 V to +40 V, -10 V to +30 V, or 0 V to 20 V.

The subthreshold swing (SS) of the Al-Sb-O-based oxide semiconductor device may be, for example, 0.1 V/decade or more, 0.5 V/decade or more, 1 V/decade or more, 1.5 V/decade or more, or 2 V/decade or more, and 30 V/decade or less, 10 V/decade or less, 5 V/decade or less, or 3 V/decade or less. As a specific example, the subthreshold swing (SS) of the Al-Sb-O-based oxide semiconductor device may be 0.1 V/decade to 30 V/decade, 0.1 V/decade to 10 V/decade, 0.1 V/decade to 3 V/decade, or 1 V/decade to 30 V/decade.

In an embodiment, the Al-Sb-O-based oxide semiconductor device may have n-type characteristics, a field effect mobility (µ_{FE}) of 0.1 cm²/Vs to 10 cm²/Vs, an on/off ratio of 1.0×10³ to 1.0×10⁷, a threshold voltage (Vₜₕ) of -40 V to +40 V, a subthreshold swing (SS) of 0.1 V/decade to 10 V/decade.

In another embodiment, the Al-Sb-O-based oxide semiconductor device may have p-type characteristics, a field effect mobility (µ_{FE}) of 0.01 cm²/Vs to 1 cm²/Vs, an on/off ratio of 1.0×10² to 1.0×10⁵, a threshold voltage (Vₜₕ) of -40 V to +40 V, a subthreshold swing (SS) of 0.1 V/decade to 3 V/decade.

### Method for manufacturing the oxide semiconductor (solution process)

According to the present invention, the oxide semiconductor may be manufactured by a solution process or a deposition process.

According to an embodiment, the oxide semiconductor may be manufactured by a solution process, for example, a sol-gel process.

For example, the method for manufacturing the oxide semiconductor comprises mixing a first precursor solution containing an aluminum precursor and a second precursor solution containing an antimony precursor to prepare a sol-gel solution; and coating the sol-gel solution on a substrate to form an oxide semiconductor thin film.

The types of aluminum precursor and antimony precursor used to manufacture the oxide semiconductor are not particularly limited.

For example, the aluminum precursor may be at least one selected from the group consisting of aluminum chloride, aluminum chloride hexahydrate, aluminum acetate, aluminum diacetate, aluminum acetylacetonate, aluminum sulfate hydrate, aluminum hydroxide hydrate, and aluminum isopropoxide.

In addition, the antimony precursor may be at least one selected from the group consisting of antimony chloride (III), antimony chloride (V), antimony acetate (III), antimony sulfide (III), antimony sulfide (V), antimony fluoride (III), antimony fluoride (V), and antimony ethoxide.

The first precursor solution may comprise a first solvent, and the second precursor solution may comprise a second solvent.

The first solvent and the second solvent are not particularly limited as long as they are solvents that can dissolve or disperse the aluminum precursor and the antimony precursor.

Specifically, the first solvent and the second solvent may each be at least one selected from the group consisting of acetonitrile, ethylene glycol, 2-methoxyethanol, ethanol, methanol, dimethylformamide, dimethyl sulfoxide, and deionized water.

Accordingly, the sol-gel solution may comprise at least one solvent selected from the group consisting of acetonitrile, ethylene glycol, 2-methoxyethanol, ethanol, methanol, dimethylformamide, dimethyl sulfoxide, and deionized water. The sol-gel solution may comprise a mixed solvent of one or two types of solvents. As an example, it may comprise a mixed solvent of acetonitrile and ethylene glycol.

In an example, the aluminum precursor comprises aluminum acetate, aluminum diacetate, or the like, the antimony precursor comprises antimony acetate or the like, and the sol-gel solution comprises an alcohol-based solvent such as 2-methoxyethanol, methanol, ethanol, or the like.

In another example, the aluminum precursor comprises aluminum acetate or the like, the antimony precursor comprises antimony chloride or the like, and the sol-gel solution comprises an aprotic polar solvent such as dimethylformamide, dimethyl sulfoxide, or the like.

In another example, the aluminum precursor comprises aluminum chloride or the like, the antimony precursor comprises antimony chloride or the like, and the sol-gel solution comprises a mixed solvent of acetonitrile and ethylene glycol. The weight ratio of acetonitrile and ethylene glycol in the mixed solvent may be 10:1 to 1:10.

The concentration of the sol-gel solution (i.e., the content of the precursors) may be 0.01 M or more, 0.05 M or more, 0.1 M or more, or 0.5 M or more, and may be 10 M or less, 5 M or less, 3 M or less, 2 M or less, and 1.5 M or less, or 1 M or less. As a specific example, the concentration of the sol-gel solution may be in the range of 0.05 M to 3 M.

The first precursor solution and the second precursor solution may further comprise one or more additives. The additive may be selected from the group consisting of, for example, deionized water, hydrogen peroxide, monoethanolamine (MEA), and acetylacetone. Accordingly, the sol-gel solution may further comprise one or more additives selected from the group consisting of deionized water, hydrogen peroxide, monoethanolamine, and acetylacetone. The content of the additives may be 0.01% by weight or more, 0.1% by weight or more, or 0.5% by weight or more, and 20% by weight or less, 10% by weight or less, 5% by weight or less, or 1% by weight or less, based on the total weight of the sol-gel solution. In a specific example, the sol-gel solution may further comprise 1% to 20% by weight of deionized water based on the total weight of the sol-gel solution. In another specific example, the sol-gel solution may further comprise 0.1% to 5% by weight of monoethanolamine based on the total weight of the sol-gel solution.

The first precursor solution and the second precursor solution are stirred under constant temperature conditions using a heating device such as a hot plate to be prepared into a sol-gel solution. The temperature (sol-gel reaction temperature) during the preparation of the sol-gel solution may be 20°C or higher, 40°C or higher, 60°C or higher, or 80°C or higher, and may be 200°C or lower, 150°C or lower, or 120°C or lower. The time required to prepare the sol-gel solution may be 1 hour or more, 2 hours or more, or 3 hours or more, and may be 10 hours or less, 8 hours or less, or 6 hours or less. As a specific example, the preparation of the sol-gel solution may be carried out at 25°C to 140°C for 1 hour to 72 hours.

The coating may be carried out using spin coating, dip coating, bar coating, or doctor blade. The spin coating speed may be, for example, 500 rpm or more, 1,000 rpm or more, or 1,500 rpm or more, and may be 6,000 rpm or less, 4,000 rpm or less, or 3,000 rpm or less.

The coating layer obtained after the coating may be subjected to thermal treatment.

The thermal treatment may be carried out in an air or nitrogen atmosphere.

The thermal treatment temperature may be 60°C or higher, 90°C or higher, 100°C or higher, 120°C or higher, or 150°C or higher, and may be 1,000°C or lower, 900°C or lower, 700°C or lower, 500°C or lower, 300°C or lower, or 200°C or lower. The thermal treatment time may be 10 seconds or more, 30 seconds or more, 1 minute or more, 5 minutes or more, 10 minutes or more, or 30 minutes or more, and may be 7 hours or less, 5 hours or less, 3 hours or less, 2 hours or less, or 1 hour or less. As a specific example, the thermal treatment may be carried out at a temperature of 150°C to 1,000°C for 30 minutes to 5 hours. More specifically, the thermal treatment may be carried out for 1 hour, 3 hours, or 5 hours.

The thermal treatment may be carried out once or twice or more. For example, at least one selected from thermal treatment at a temperature of 90°C to 200°C for 30 seconds to 1 hour, thermal treatment at a temperature of 90°C to 200°C for 1 minute to 1 hour, thermal treatment at a temperature of 150°C to 900°C for 30 minutes to 5 hours, and thermal treatment at a temperature of 80°C to 300°C for 10 minutes to 3 hours may be carried out. Alternatively, two or more thereof may be carried out sequentially.

The thermal treatment may be carried out through a heating device such as an oven or electric furnace.

In addition, a thermal treatment step for drying and gelating the coating layer may be carried out in advance before the thermal treatment. The thermal treatment for drying and gelation may be a common thermal treatment using a hot plate or the like. For example, the thermal treatment temperature for drying and gelation may be 100°C or higher, 110°C or higher, 120°C or higher, or 130°C or higher, and may be 200°C or lower, 180°C or lower, 160°C or lower, 150°C or lower, or 140°C or lower. In addition, the thermal treatment time for drying and gelation may be 30 seconds or more, 1 minute or more, 3 minutes or more, 5 minutes or more, or 10 minutes or more, and 2 hours or less, 1 hour or less, 30 minutes or less, or 20 minutes or less.

### Method for manufacturing the oxide semiconductor (deposition process)

According to another embodiment, the oxide semiconductor may be manufactured by a deposition process. Specifically, the oxide semiconductor may be manufactured by vacuum deposition (vapor deposition), more specifically, sputtering deposition.

For example, the method for manufacturing the oxide semiconductor comprises sputtering-depositing an aluminum precursor and an antimony precursor on a substrate to form an oxide semiconductor thin film containing aluminum and antimony.

The aluminum precursor may comprise aluminum oxide, and the antimony precursor may comprise antimony oxide.

The aluminum oxide may comprise, for example, Al₂O₃, and the antimony oxide may comprise, for example, Sb₂O₃.

Accordingly, the oxide semiconductor manufactured by sputtering deposition may have, for example, a composition as shown in the following Formula 2.

[Formula 2] (Al₂O₃)₁₋ₐ(Sb₂O₃)ₐ

In the above formula, 0 < a < 1.

The sputtering deposition may be carried out using, for example, DC sputtering, RF sputtering, magnetron sputtering, bias sputtering, reactive sputtering, or the like.

The sputtering deposition may use a discharge gas, for example, an inert gas such as argon gas, helium gas, neon gas, xenon gas, or the like. In addition, the sputtering deposition may further use a reaction gas, for example, oxygen gas.

Specifically, the sputtering deposition may be carried out by injecting argon gas and oxygen gas. For example, the partial pressure of oxygen gas may be 0% or more, 0.5% or more, 1% or more, 2% or more, or 5% or more, and may be 20% or less, 15% or less, or 10% or less, based on the partial pressure of argon gas.

Specifically, the partial pressure ratio of argon gas and oxygen gas may be in the range of 20:0.1 to 20:2. More specifically, the partial pressure ratio of argon gas and oxygen gas may be 20:0.1 to 20:1.5, 20:0.1 to 20:0.7, 20:0.1 to 20:0.3, 20:0.3 to 20:2, 20:0.7 to 20:2, or 20:0.3 to 20:0.7.

The RF power applied during the sputtering deposition may be 20 W or more, 25 W or more, 30 W or more, or 50 W or more, and may be 500 W or less, 300 W or less, 200 W or less, 150 W or less, or 100 W or less, as a specific example, 25 W to 200 W.

The operating pressure during the sputtering deposition may be 0.1 mTorr or more, 0.2 mTorr or more, 0.5 mTorr or more, or 1 mTorr or more, and may be 10 mTorr or less, 5 mTorr or less, 3 mTorr or less, or 2 mTorr or less, as a specific example, 0.2 mTorr to 3 mTorr.

The method for manufacturing the oxide semiconductor according to the above embodiment may further comprise thermal treatment after sputtering deposition.

The thermal treatment may be carried out in an air or nitrogen atmosphere.

The thermal treatment temperature may be 60°C or higher, 90°C or higher, 100°C or higher, 120°C or higher, or 150°C or higher, and may be 1,000°C or lower, 900°C or lower, 700°C or lower, 500°C or lower, 300°C or lower, or 200°C or lower. The thermal treatment time may be 10 seconds or more, 30 seconds or more, 1 minute or more, 5 minutes or more, 10 minutes or more, or 30 minutes or more, and may be 7 hours or less, 5 hours or less, 3 hours or less, 2 hours or less, or 1 hour or less. As a specific example, the thermal treatment may be carried out at a temperature of 150°C to 1,000°C for 30 minutes to 5 hours. More specifically, the thermal treatment may be carried out for 1 hour, 3 hours, or 5 hours.

The thermal treatment may be carried out through a heating device such as an oven or electric furnace.

Alternatively, the thermal treatment may be carried out through electron beam treatment.

For example, a target to be heated is placed inside the chamber of an electron beam accelerator, it is filled with discharge gas, and RF power is then applied to create a plasma state to separate the discharge gas into electrons and ions. When DC voltage is applied, electrons are accelerated in the form of an electron beam as they pass through the accelerating tube and quickly reach and hit the surface of the target. Such electron beam treatment has the same effect as thermal treatment, while it has the advantage of enhancing the composition, crystallinity, and electrical properties after the electron beam treatment.

Argon gas, helium gas, neon gas, or xenon gas may be used as the discharge gas during the electron beam treatment. The flow rate of the discharge gas may be, for example, 1 sccm or more, 5 sccm or more, or 10 sccm or more, and may be 50 sccm or less, 30 sccm or less, or 15 sccm or less.

In addition, during the electron beam treatment, the density of the plasma can be controlled by adjusting the radio frequency (RF) power, and the degree of acceleration of the electron beam can be controlled by adjusting the direct current (DC) voltage, making it possible to manufacture metal oxide layers with various characteristics.

For example, the RF power for controlling the plasma density during the electron beam treatment may be adjusted to 100 W or more, 150 W or more, 200 W or more, 250 W or more, or 300 W or more, and may be adjusted to 700 W or less, 500 W or less, or 450 W or less, 400 W or less, or 350 W or less. In addition, the DC voltage for electron beam acceleration during the electron beam treatment may be adjusted to 100 V or more, 200 V or more, 300 V or more, 400 V or more, or 500 V or more, and may be adjusted to 1,500 V or less, 1,300 V or less, 1,100 V or less, 900 V or less, 800 V or less, 700 V or less, or 600 V or less. In addition, the electron beam treatment time may be 10 seconds or more, 30 seconds or more, 1 minute or more, 2 minutes or more, or 3 minutes or more, and may be 30 minutes or less, 20 minutes or less, 10 minutes or less, 7 minutes or less, or 5 minutes or less. As a specific example, the electron beam treatment may be carried out for 30 seconds to 10 minutes at an RF power of 150 W to 500 W and a DC voltage of 200 V to 1,000 V.

The oxide semiconductor thin film thus prepared in this way may have a thickness of 1 nm or more, 5 nm or more, 10 nm or more, 20 nm or more, or 30 nm or more, and may be 500 nm or less, 300 nm or less, 200 nm or less, 100 nm or less, or 50 nm or less. As an example, the thickness of the oxide semiconductor thin film may be 5 nm to 50 nm. As a specific example, the thickness of the oxide semiconductor thin film may be 10 nm to 100 nm. More specifically, the thickness of the oxide semiconductor thin film may be 10 nm to 50 nm, 10 nm to 40 nm, 10 nm to 25 nm, 20 nm to 100 nm, 20 nm to 50 nm, 20 nm to 40 nm, 40 nm to 100 nm, or 20 nm to 40 nm.

### Semiconductor device

The oxide semiconductor according to the present invention has excellent electrical conductivity and band gap, so that it can be applied to semiconductor devices Accordingly, the present invention provides a semiconductor device comprising the oxide semiconductor described above.

The semiconductor device according to the present invention comprises a substrate and a semiconductor layer formed on the substrate, wherein the semiconductor layer comprises the oxide semiconductor described above. In addition, the semiconductor device may further comprise a dielectric layer between the substrate and the semiconductor layer. In addition, the semiconductor device may further comprise an electrode on the semiconductor layer.

Fig. 2 is a cross-sectional view of a semiconductor device comprising the oxide semiconductor according to an embodiment. Referring to Fig. 2, the semiconductor device according to an embodiment comprises a substrate (100), a dielectric layer (200) formed on the substrate (100), a semiconductor layer (300) comprising an oxide semiconductor formed on the dielectric layer (200), and an electrode (400) formed on the semiconductor layer (300). Here, the oxide semiconductor comprises an oxide containing aluminum (Al) and antimony (Sb) as described above.

The substrate is a base for forming a semiconductor device and is not particularly limited in terms of material, but it may be, for example, silicon, glass, plastic, metal foil, or the like. The substrate may be plate-shaped or may be formed to have a specific pattern by depositing and patterning a metal material such as molybdenum (Mo) or aluminum (Al) on the substrate. Alternatively, the substrate may comprise a metal or a metal oxide as a conductive material to be used as a gate electrode. Specifically, it may comprise at least one of molybdenum (Mo), aluminum (Al), chromium (Cr), gold (Au), titanium (Ti), and silver (Ag). The thickness of the substrate is not particularly limited, but it may be, for example, 0.01 mm or more, 0.1 mm or more, 0.5 mm or more, or 1 mm or more, and may be 10 mm or less, 5 mm or less, 3 mm or less, or 2 mm or less.

The dielectric layer is formed on the substrate and serves to insulate the substrate, the semiconductor layer, and the electrode. The dielectric layer may comprise an insulation material used in common semiconductor processes. For example, the dielectric layer may comprise at least one of a dielectric selected from the group consisting of silicon oxide (SiO₂), hafnium oxide (HfO₂), aluminum oxide (Al₂O₃), zirconium oxide (ZrO₂), and silicon nitride (Si₃N₄). The dielectric layer may be formed using a method such as vacuum deposition, chemical vapor deposition, physical vapor deposition, atomic layer deposition, organic metal chemical vapor deposition, plasma chemical vapor deposition, molecular beam epitaxy, hydride vapor epitaxy, sputtering, spin coating, and dip coating. The dielectric layer may have a thickness of 10 nm or more, 20 nm or more, 30 nm or more, or 50 nm or more, and may be 500 nm or less, 300 nm or less, 200 nm or less, or 100 nm or less. As an example, the thickness of the dielectric layer may be 50 nm to 200 nm.

The semiconductor layer is composed of the oxide semiconductor described above; that is, it comprises an oxide containing aluminum (Al) and antimony (Sb). The semiconductor layer may be formed by a solution process or a deposition process as described above. The semiconductor layer may further comprise an additional oxide semiconductor other than the oxide semiconductor of the present invention. The additional oxide semiconductor may be at least one selected from, for example, indium gallium zinc oxide (IGZO), indium tin zinc oxide (ITZO), zinc oxide (ZnO), indium zinc oxide (IZO), indium oxide (InO), indium tin oxide (ITO), indium gallium oxide (IGO), zinc tin oxide (ZTO), silicon indium zinc oxide (SIZO), gallium zinc oxide (GZO), hafnium indium zinc oxide (HIZO), and aluminum zinc tin oxide (AZTO). The semiconductor layer may have a thickness of 1 nm or more, 5 nm or more, 10 nm or more, 20 nm or more, or 30 nm or more, and may be 500 nm or less, 300 nm or less, 200 nm or less, 100 nm or less, or 50 nm or less. As an example, the thickness of the semiconductor layer may be 5 nm to 50 nm. As a specific example, the thickness of the semiconductor layer may be 10 nm to 100 nm. More specifically, the thickness of the semiconductor layer may be 10 nm to 50 nm, 10 nm to 40 nm, 10 nm to 25 nm, 20 nm to 100 nm, 20 nm to 50 nm, 20 nm to 40 nm, 40 nm to 100 nm, or 20 nm to 40 nm.

The electrode may comprise a source electrode and a drain electrode, which are disposed to be spaced apart from each other and may be electrically connected to the semiconductor layer. The electrode may be formed of a metal material. For example, it may comprise at least one selected from the group consisting of molybdenum (Mo), aluminum (Al), chromium (Cr), gold (Au), titanium (Ti), nickel (Ni), neodymium (Nd), copper (Cu), indium tin oxide (ITO), indium zinc oxide (IZO), and indium tin zinc oxide (ITZO), but it is not limited thereto. The electrode may be obtained by depositing a conductive film on the semiconductor layer, forming a photoresist pattern thereon, and then using it as a mask to pattern the conductive film. The conductive film may be formed using a method such as vacuum deposition, chemical vapor deposition, physical vapor deposition, atomic layer deposition, organic metal chemical vapor deposition, plasma chemical vapor deposition, molecular beam epitaxy, hydride vapor epitaxy, sputtering, spin coating, and dip coating.

The electrode may have a thickness of 5 nm or more, 10 nm or more, 30 nm or more, or 50 nm or more, and may be 500 nm or less, 300 nm or less, 200 nm or less, or 100 nm or less. As an example, the thickness of the electrode may be 10 nm to 200 nm.

The semiconductor device of the present invention can be used as a field effect transistor (FET) applied to display devices and can specifically be used as a thin film transistor (TFT).

Accordingly, the present invention provides a field effect transistor and a thin film transistor comprising the semiconductor device described above.

Specifically, the semiconductor device of the present invention can be used as a transistor such as a pixel-driving device used in a liquid crystal display (LCD) or organic light emitting display (OLED) device.

The semiconductor device according to the present invention is excellent in terms of field effect mobility (µ_{FE}), on/off ratio, threshold voltage (Vₜₕ), and subthreshold swing (SS); thus, it can be adopted in display devices or the like by replacing the oxide semiconductors (e.g., IGZO) conventionally used.

Accordingly, the present invention also provides a display device that comprises the thin film transistor.

As an example, the display device is a liquid crystal display (LCD) device, wherein the liquid crystal display device may comprise a polarizer, a liquid crystal display panel, a backlight unit, and other optical sheets. Specifically, the liquid crystal display panel may comprise a color filter, a liquid crystal cell, and a driving substrate, and the driving substrate may be equipped with a thin film transistor.

As another example, the display device is an organic light emitting display (OLED) device, and the organic light emitting display device may comprise a polarizer and an organic light emitting display panel. Specifically, the organic light emitting display panel may comprise an organic light emitting substrate and a driving substrate, and the driving substrate may be equipped with a thin film transistor.

A display device using a thin film transistor containing the Al-Sb-O-based oxide semiconductor of the present invention as described above can exhibit excellent performance.

### Mode for the Invention

Hereinafter, examples are described to aid understanding of the present invention. However, the present invention is not limited to the scope of these examples.

### Example A: Preparation of an Al-Sb-O-based oxide semiconductor through a solution process

### Step 1: Preparation of a sol-gel solution

0.1 M of aluminum acetylacetonate and 0.1 M of antimony acetate were added to 5 mL of 2-methoxyethanol as a solvent, and 120 µL of monoethanolamine as a catalyst was added thereto. It was then stirred at 700 RPM for 2 hours in a stirrer at 80°C to prepare an Al-Sb-O-based sol-gel solution.

### Step 2: Preparation of a sol-gel coating layer

The sol-gel solution thus prepared was filtered through a 1-µm syringe filter. To enhance the surface characteristics of a Si substrate on which a 100-nm SiO₂ dielectric layer was deposited, UV/ozone (UVO) treatment was carried out for 10 minutes. Thereafter, 150 µL of the filtered Al-Sb-O-based sol-gel solution was applied onto the substrate, and spin coating was carried out at 3,000 rpm for 20 seconds using a spin coater. After the coating, thermal treatment was carried out on a hot plate at 150°C for 10 minutes to form a coating layer (thin film).

### Step 3: Thermal treatment

In order to oxidize the formed thin film and enhance the physical properties of the thin film, thermal treatment was carried out using an electric furnace. In such an event, the thermal treatment was carried out for 1 to 5 hours under various temperature conditions in the range of 200 to 800°C.

Thereafter, an ITO electrode with a thickness of 100 nm was deposited on the oxide semiconductor thin film to manufacture a thin film transistor (TFT), whose characteristics were tested.

Various oxide semiconductors were manufactured by performing a solution process according to the method of Example A using the solvent, precursor, and process conditions shown in Tables 1 and 2 below.

**[Table 1]**

| Solvent | | Precursor | | Cone. | Temp. | Stirring |
|---|---|---|---|---|---|---|
| Acetonitrile (5 mL) | Ethylene glycol (5 mL) | AlCl₃ (0.4 M) | SbCl₃ (0.4 M) | 0.8 M | 80°C | 6 h |
| Acetonitrile (5 mL) | Ethylene glycol (4.5 mL) | AlCl₃ (0.4 M) | SbCl₃ (0.4 M) | 0.8 M | 80°C | 6 h |
| Acetonitrile (5 mL) | Ethylene glycol (4 mL) | AlCl₃ (0.4 M) | SbCl₃ (0.4 M) | 0.8 M | 80°C | 6 h |
| Acetonitrile (9 mL) | Ethylene glycol (0.9 mL) | AlCl₃ (0.4 M) | SbCl₃ (0.4 M) | 0.8 M | 80°C | 6 h |
| Acetonitrile (9 mL) | Ethylene glycol (1 mL) | AlCl₃ (0.4 M) | SbCl₃ (0.4 M) | 0.8 M | 80°C | 6 h |
| Acetonitrile (6 mL) | Ethylene glycol (4 mL) | AlCl₃ (0.2 M) | SbCl₃ (0.6 M) | 0.8 M | 80°C | 6 h |
| Acetonitrile (9 mL) | Ethylene glycol (1 mL) | AlCl₃ (0.2 M) | SbCl₃ (0.6 M) | 0.8 M | 80°C | 6 h |
| Acetonitrile (6 mL) | Ethylene glycol (4 mL) | AlCl₃ (0.3 M) | SbCl₃ (0.9 M) | 1.2 M | 80°C | 6 h |
| Acetonitrile (6 mL) | Ethylene glycol (4 mL) | AlCl₃ (0.4 M) | SbCl₃ (1.2 M) | 1.6 M | 80°C | 6 h |
| Acetonitrile (6 mL) | Ethylene glycol (4 mL) | AlCl₃ (0.5 M) | SbCl₃ (1.5 M) | 2.0 M | 80°C | 6 h |
| Acetonitrile (6 mL) | Ethylene glycol (4 mL) | AlCl₃ (0.7 M) | SbCl₃ (2.1 M) | 2.8 M | 80°C | 6 h |
| Acetonitrile (6 mL) | Ethylene glycol (4 mL) | AlCl₃ (0.6 M) | SbCl₃ (0.6 M) | 1.2 M | 80°C | 6 h |
| Acetonitrile (3.5 mL) | Ethylene glycol (6.5 mL) | AlCl₃ (0.2 M) | SbCl₃ (0.2 M) | 0.4 M | 80°C | 6 h |
| Acetonitrile (3.5 mL) | Ethylene glycol (6.5 mL) | AlCl₃ (0.4 M) | SbCl₃ (0.4 M) | 0.8 M | 80°C | 6 h |
| Acetonitrile (3.5 mL) | Ethylene glycol (6.5 mL) | AlCl₃ (0.4 M) | SbCl₃ (0.2 M) | 0.6 M | 80°C | 6 h |

**[Table 2]**

| Solvent | Precursor | | Conc. | Temp. | Stirring |
|---|---|---|---|---|---|
| 2-Methoxyethanol | Al(NO₃)₃ 9H₂O | Sb(CH₃CO₂)₃ | 0.2 M | 80°C | 6 h |
| (10 mL) | (0.1 M) | (0.1 M) | | | |
| 2-Methoxyethanol (10 mL) | Al(NO₃)₃ 9H₂O (0.1 M) | SbCl₃ (0.1 M) | 0.2 M | 80°C | 6 h |
| DMSO (3 mL) | Dibasic Al acetate (0.1 M) | SbCl₃ (0.1 M) | 0.2 M | 80°C | 6 h |
| 2-Methoxyethanol (5 mL) | AlCl₃ (0.1 M) | SbCl₅ (0.1 M) | 0.2 M | 80°C | 6 h |
| 2-Methoxyethanol (5 mL) | AlCl₃ (0.2 M) | SbCl₅ (0.5 M) | 0.7 M | 80°C | 6 h |
| 2-Methoxyethanol (5 mL) | AlCl₃ (0.2 M) | SbCl₃(0.2 M) | 0.4 M | 80°C | 6 h |
| 2-Methoxyethanol (5 mL) | AlCl₃ (0.1 M) | SbCl₃ (0.3 M) | 0.4 M | 80°C | 6 h |
| 2-Methoxyethanol (5 mL) | AlCl₃ (0.075 M) | SbCl₃ (0.325 M) | 0.4 M | 80°C | 6 h |
| 2-Methoxyethanol (5 mL) | Al acetylacetonate (0.1 M) | SbCl₃ (0.1 M) | 0.2 M | 80°C | 6 h |
| 2-Methoxyethanol (5 mL) | Al acetylacetonate (0.11 M) | SbCl₃ (0.1 M) | 0.21 M | 80°C | 6 h |
| 2-Methoxyethanol (5 mL) | Al acetylacetonate (0.12 M) | SbCl₃ (0.1 M) | 0.22 M | 80°C | 6 h |
| 2-Methoxyethanol (5 mL) | Al acetylacetonate (0.13 M) | SbCl₃ (0.1 M) | 0.23 M | 80°C | 6 h |
| 2-Methoxyethanol (5 mL) | Al acetylacetonate (0.15 M) | SbCl₃ (0.1 M) | 0.25 M | 80°C | 6 h |
| 2-Methoxyethanol (5 mL) | Al acetylacetonate (0.2 M) | SbCl₃ (0.1 M) | 0.3 M | 80°C | 6 h |

Table 3 below shows the band gap and electrical conductivity of the Al-Sb-O-based oxide semiconductor according to an example, which is confirmed to be at a level applicable to thin film transistors. Here, the band gap was calculated by measuring the absorbance of a sample with a UV-visible spectrometer and drawing a Tauc plot, and the electrical conductivity was calculated using the First-principles calculations and Boltzmann transport equation.

**[Table 3]**

| Formula | Space group | Band gap | Electrical conductivity (1/fΩ/m/s) | |
|---|---|---|---|---|
| Formula | Space group | Band gap | n-type | p-type |
| AlSbO₄ | Cmmm | 3.72 eV | 99.456 | 20.3094 |

### Example A1: Changes in the composition ratio of Al and Sb

The same procedure as in Example A was repeated, except that 2-methoxyethanol, or acetonitrile/ethylene glycol, was used as a solvent, a sol-gel solution containing an aluminum precursor and an antimony precursor was prepared, and it was then spin-coated to obtain an oxide semiconductor thin film with a thickness of 27 nm, which was thermally treated at 400°C. In such an event, the precursor molar ratio was changed to adjust the element molar ratio of Al:Sb in the Al-Sb-O-based oxide semiconductor thin film to 5:1, 3:1, 1:1, 1:3, or 1:5. Thereafter, an ITO electrode was deposited on the oxide semiconductor thin film to manufacture a thin film transistor (TFT), whose electrical characteristics were tested.

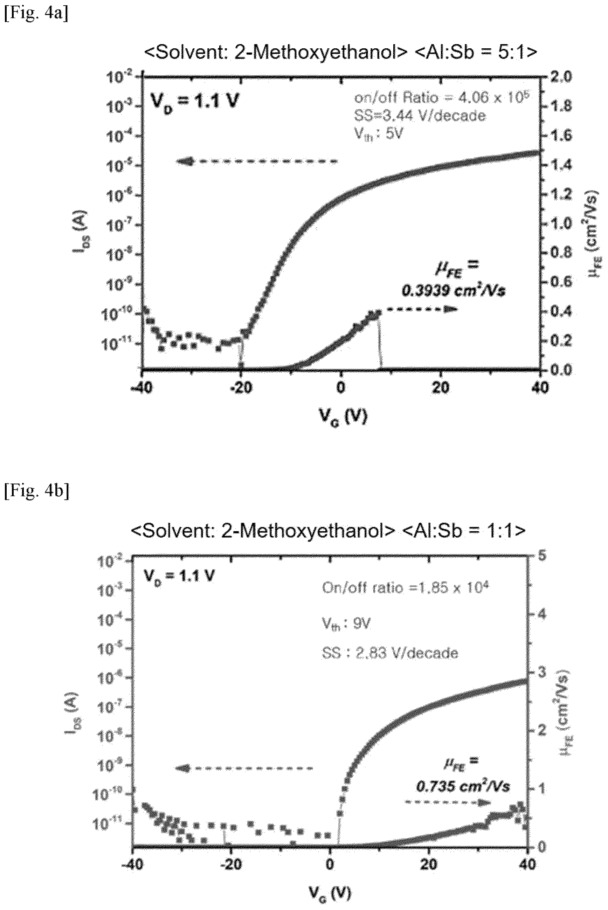

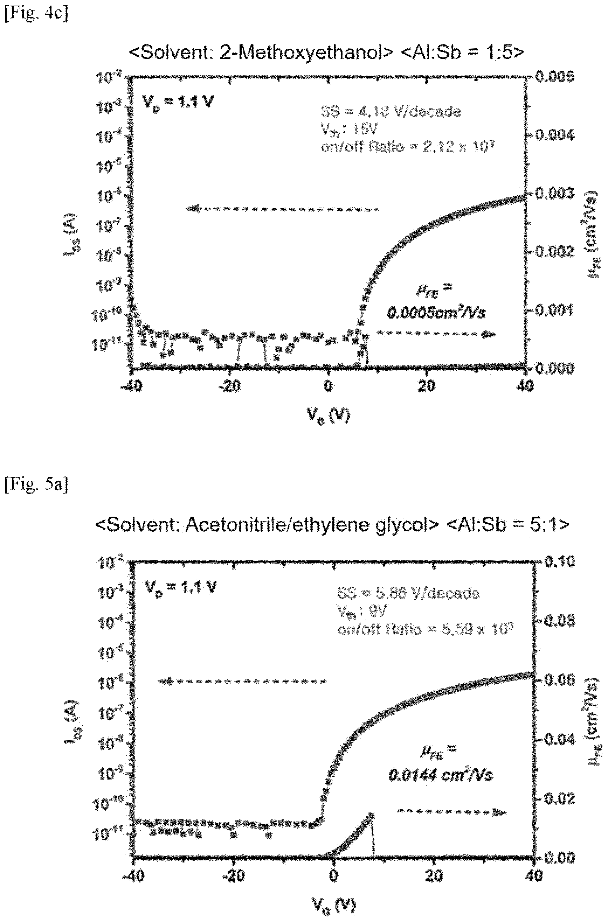

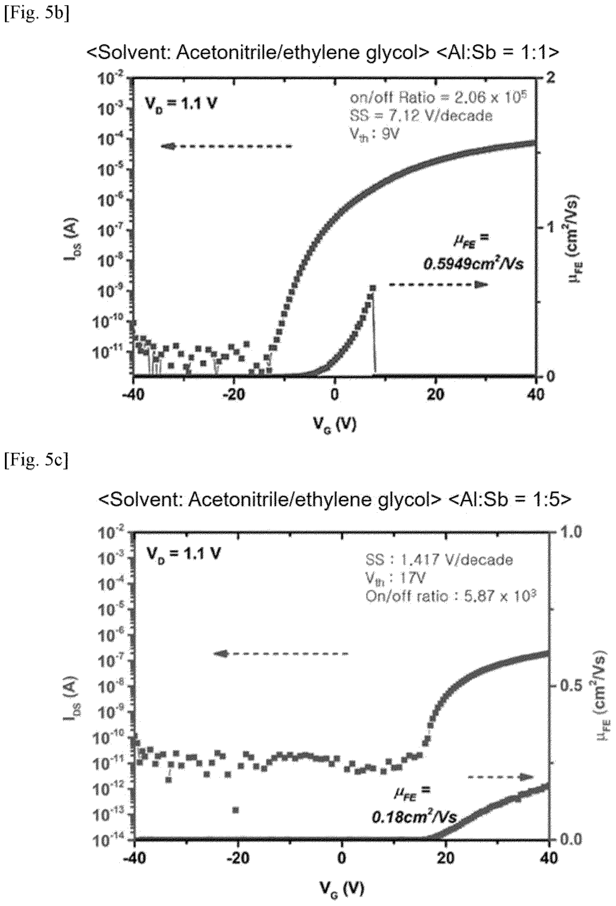

Figs. 4a to 5c show the test results of the oxide semiconductor devices manufactured by a solution process with various molar ratios of Al:Sb and solvents. As a result of the test, the field effect mobility (µ_{FE}), on/off ratio, Vₜₕ, and SS changed depending on the molar ratio of Al: Sb and solvent. The highest µ_{FE} was shown when the molar ratio of Al:Sb was about 1:1.

### Example A2: Changes in the thermal treatment conditions

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor thin film with a thickness of 27 nm. The oxide semiconductor thin film thus obtained was thermally treated at a temperature of 200°C, 400°C, 600°C, or 800°C in an air or nitrogen atmosphere. Thereafter, an ITO electrode was deposited on the oxide semiconductor thin film to manufacture a thin film transistor (TFT), whose electrical characteristics were tested.

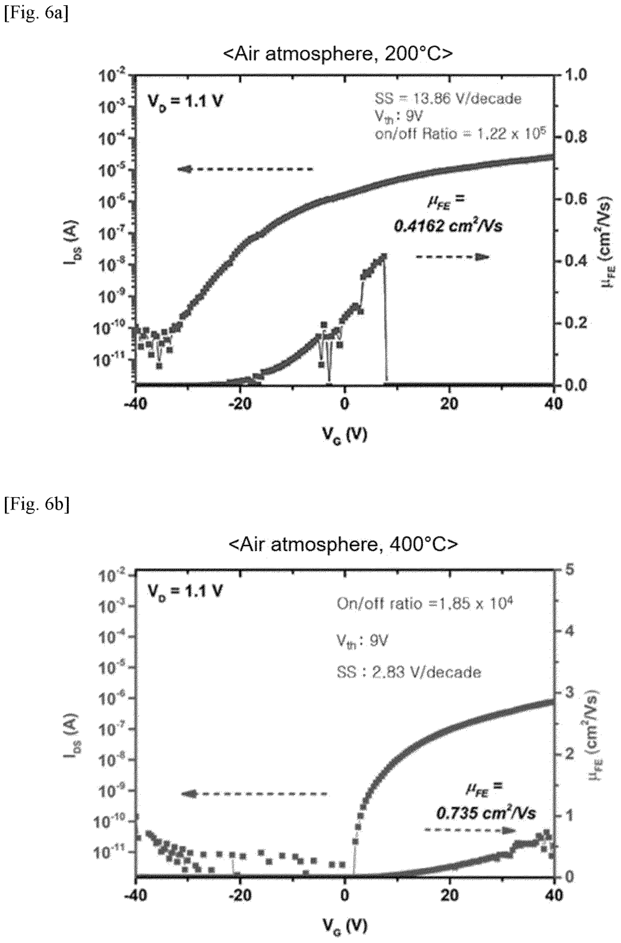

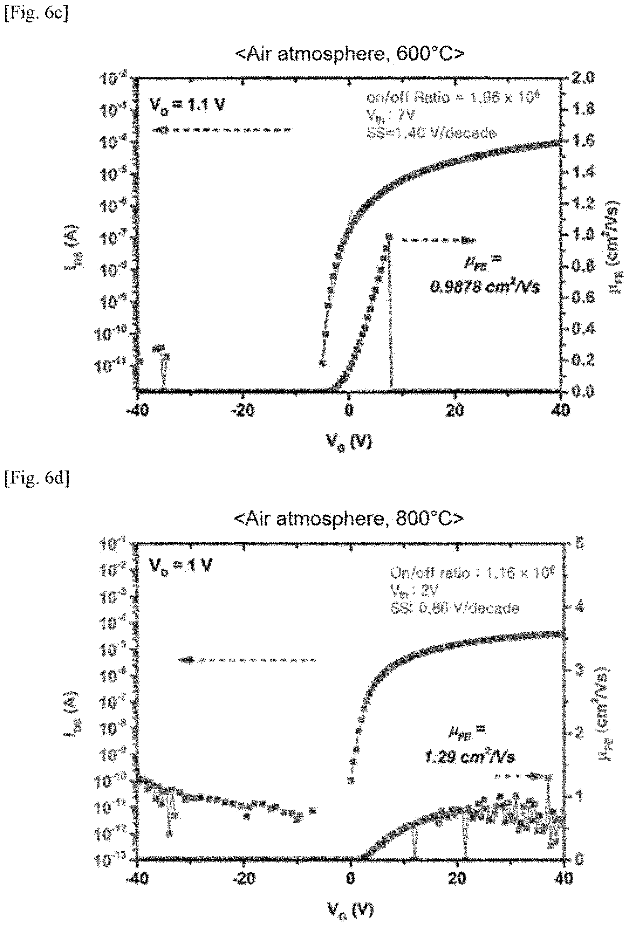

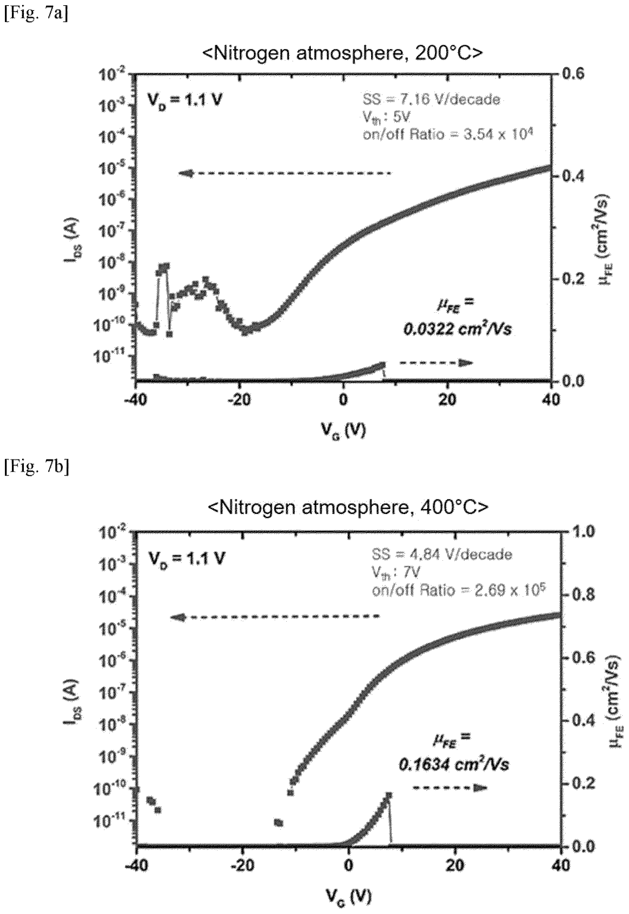

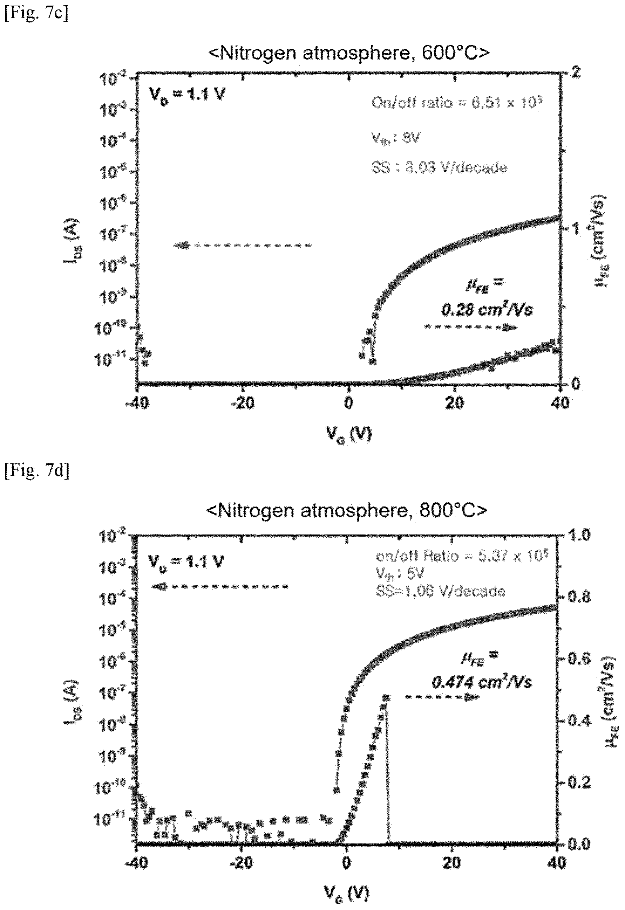

Figs. 6a to 7d show the test results of the oxide semiconductor devices thermally treated under various conditions after the solution process. As a result of the test, the field effect mobility (µ_{FE}), on/off ratio, Vₜₕ, and SS changed depending on the atmosphere (oxygen or nitrogen) and thermal treatment temperature during the thermal treatment. The highest µ_{FE} was shown when the thermal treatment temperature was approximately 400 to 600°C.

### Example A3: Changes in the thin film thickness

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor thin film, which was thermally treated at 400°C. In such an event, the rpm during spin coating was changed to adjust the thickness of the oxide semiconductor thin film to 45 nm, 35 nm, 27 nm, or 15 nm. Thereafter, an ITO electrode was deposited on the oxide semiconductor thin film to manufacture a thin film transistor (TFT), whose electrical characteristics were tested.

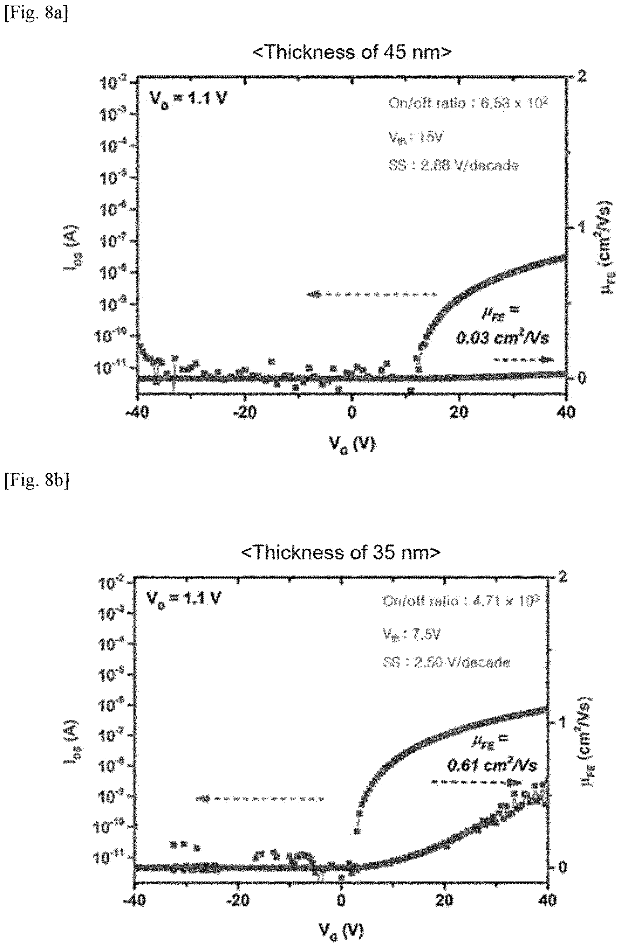

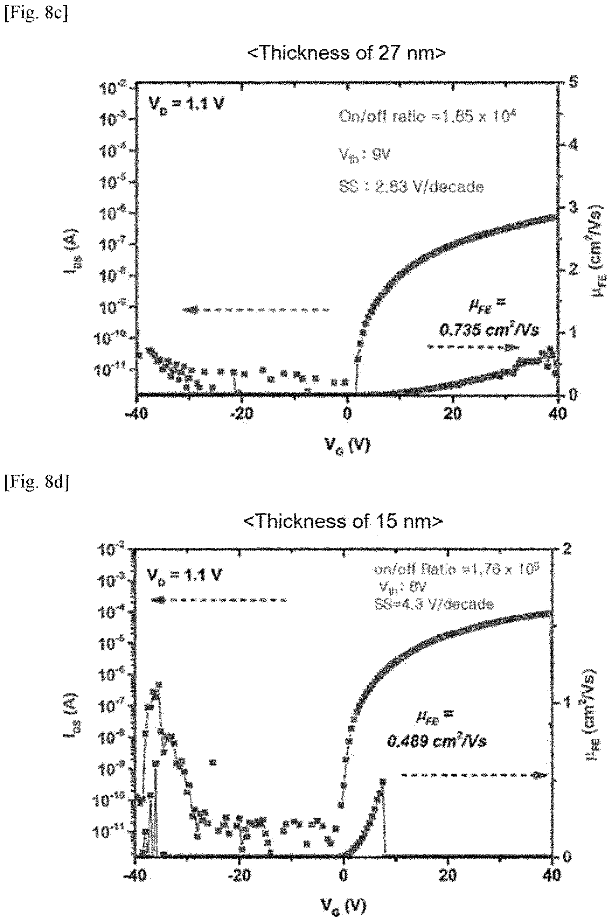

Figs. 8a to 8d show the test results of the oxide semiconductor devices manufactured with various thin film thicknesses through a solution process. As a result of the test, the field effect mobility (µ_{FE}), on/off ratio, Vₜₕ, and SS changed depending on the thickness of the oxide semiconductor thin film. The highest µ_{FE} was shown when the thickness of the oxide semiconductor thin film was approximately 20 to 30 nm.

### Example A4: Use of an additive

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor thin film, which was thermally treated at 400°C. In such an event, 0.2 mL of deionized water or 0.120 mL of monoethanolamine was further added to the sol-gel solution, and the procedure was carried out. Thereafter, an ITO electrode was deposited on the oxide semiconductor thin film to manufacture a thin film transistor (TFT), whose electrical characteristics were tested.

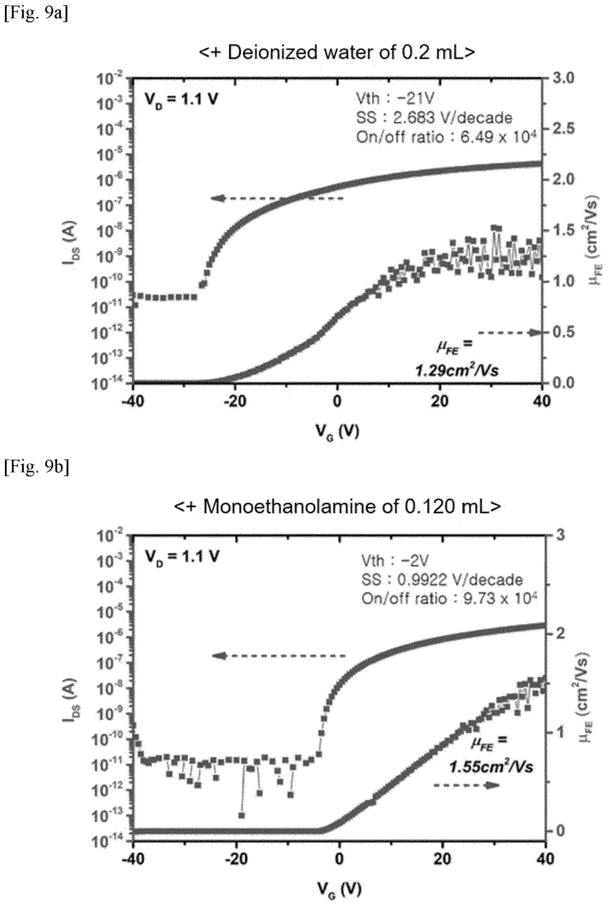

Figs. 9a to 9d show the test results of the oxide semiconductor devices manufactured through a solution process using various additives. As a result of the test, the field effect mobility (µ_{FE}), on/off ratio, Vₜₕ, and SS changed depending on the additive. High µ_{FE} was shown as compared with the case where no additive was used.

### Test Example 1: Electrical characteristics of the oxide semiconductor devices

The electrical properties of the thin film transistors (TFTs) manufactured in the Examples were tested. The electrical characteristics of the TFTs were defined by measuring both the transfer curve and the output curve. In the transfer curve, V_{G} was applied at a total of 161 points in the range of -40 to 40 V in a 0.5 V increment, and V_{D} was measured by applying various values between 0.1 V and 20.1 V. In the output curve, V_{D} was measured at a total of 81 points in the range of 0 to 40 V in a 0.5 V increment, and V_{G} was measured in the range of 0 to 25 V in a 5 V increment. The measurements were carried out using a Hewlett Packard 4145B semiconductor parameter analyzer.

### Test Example 2: TG-DTA

The synthesis conditions for an Al-Sb-O-based oxide semiconductor were confirmed using a thermogravimetric-differential thermal analyzer (TG-DTA).

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor. The oxide semiconductor thus obtained was analyzed by TG-DTA while it was subjected to thermal treatment at varying temperatures from 0°C to 1,200°C.

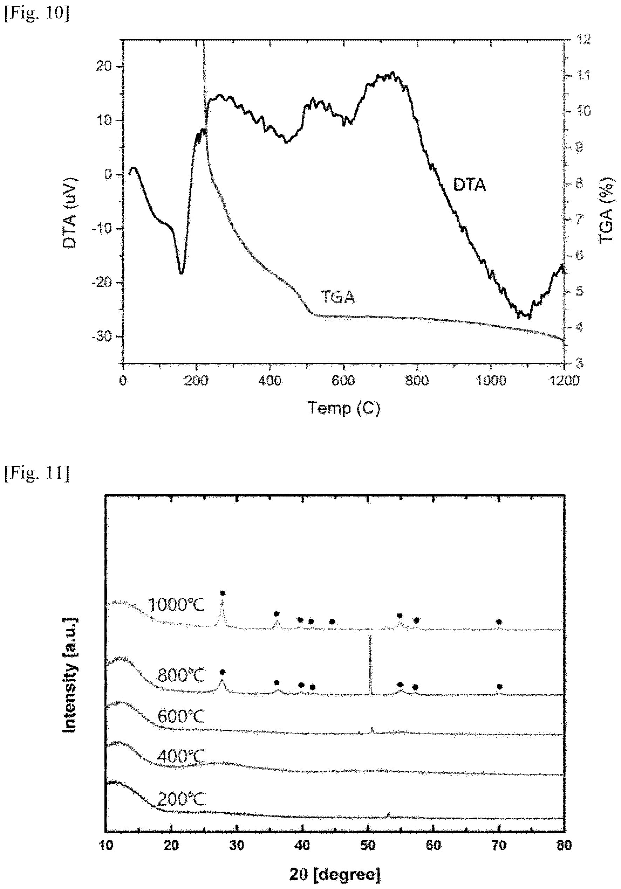

Fig. 10 shows the TG-DTA analysis results of the Al-Sb-O-based oxide semiconductor. It shows the most stable state around 500°C, indicating that sufficient synthesis was achieved.

### Test Example 3: XRD

The crystallinity and crystallization temperature of an Al-Sb-O-based oxide semiconductor were measured through X-ray diffraction (XRD) analysis.

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor thin film with a thickness of 100 nm. The oxide semiconductor thus obtained was thermally treated in air at a temperature of 200°C, 400°C, 600°C, 800°C, and 1,000°C, respectively, and XRD analysis was carried out.

Fig. 11 shows the XRD analysis results of the Al-Sb-O-based oxide semiconductor. Characteristic peaks did not appear at 200°C, 400°C, and 600°C, indicating that they were amorphous, and characteristic peaks appeared at 800°C and 1,000°C, indicating that they were crystalline.

### Test Example 4: XPS

The composition ratio of an Al-Sb-O-based oxide semiconductor was analyzed through X-ray photoelectron spectroscopy (XPS).

The same procedure as in Example A was repeated, except that 5 mL of 2-methoxyethanol was used as a solvent, a 0.8 M sol-gel solution containing 0.4 M of aluminum acetylacetonate and 0.4 M of antimony chloride as precursors was prepared, and it was then spin-coated to obtain an oxide semiconductor thin film with a thickness of 27 nm, which was thermally treated at 400°C.

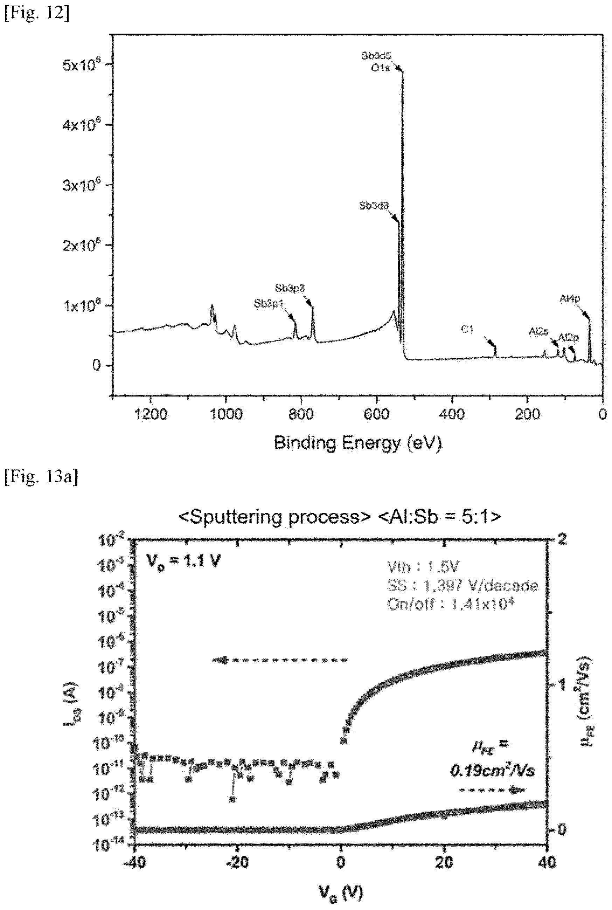

Fig. 12 shows the XPS analysis results of the Al-Sb-O-based oxide semiconductor. The content of each element contained in the oxide was calculated from this and shown in the table below. It is confirmed that the oxide semiconductor analyzed in Fig. 12 has an element molar ratio of Al and Sb of about 1:1.

**[Table 4]**

| Oxide composition | Al | Sb | O |
|---|---|---|---|
| % by element | 17.12 | 17.89 | 64.99 |

### Example B: Preparation of an Al-Sb-O-based oxide semiconductor through sputtering deposition

### Step 1: Preparation of precursors

A target of Al₂O₃ with a purity of 99.99% and a target of Sb₂O₃ with a purity of 99.99% were prepared with a thickness of 4 mm and a length of 2 inches, respectively. In order to smoothly transmit current to the targets and maintain the temperature of the bonding surface, copper (Cu) with a thickness of 2 mm was combined as a back plate.

### Step 2: Sputtering deposition

An Al-Sb-O-based thin film was deposited on a Si/SiO₂ substrate. This was carried out using a co-sputtering method by applying RF power to the Al₂O₃ and Sb₂O₃ targets, respectively. RF power was supplied in various combinations in the range of 25 to 150 W for Al₂O₃ and 15 to 70 W for Sb₂O₃.

### Step 3: Thermal treatment

In order to synthesize the formed thin film and enhance the physical properties of the thin film, thermal treatment was carried out using an electric furnace. In such an event, the thermal treatment was carried out for 1 to 5 hours under various temperature conditions within the range of 200 to 800°C.

An ITO electrode with a thickness of 100 nm was deposited on the oxide semiconductor thin film thus obtained to manufacture a thin film transistor (TFT), whose characteristics were tested.

### Example B1: Changes in the molar ratio of Al:Sb

The same procedure as in Example B was repeated to obtain an Al-Sb-O-based oxide semiconductor thin film, which was thermally treated at 400°C. In such an event, the RF power applied to the Al precursor and Sb precursor was changed to adjust the molar ratio of Al:Sb in the Al-Sb-O-based oxide semiconductor thin film to 5:1, 3 :1, 1:1, 1:3, or 1:5. Thereafter, an ITO electrode was deposited on the oxide semiconductor thin film to manufacture a thin film transistor (TFT), whose electrical characteristics were tested.

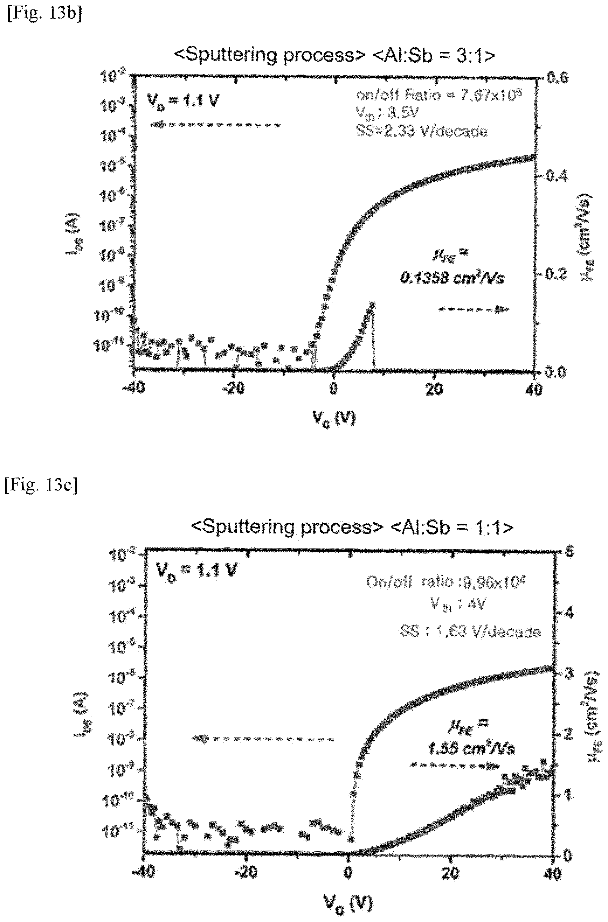

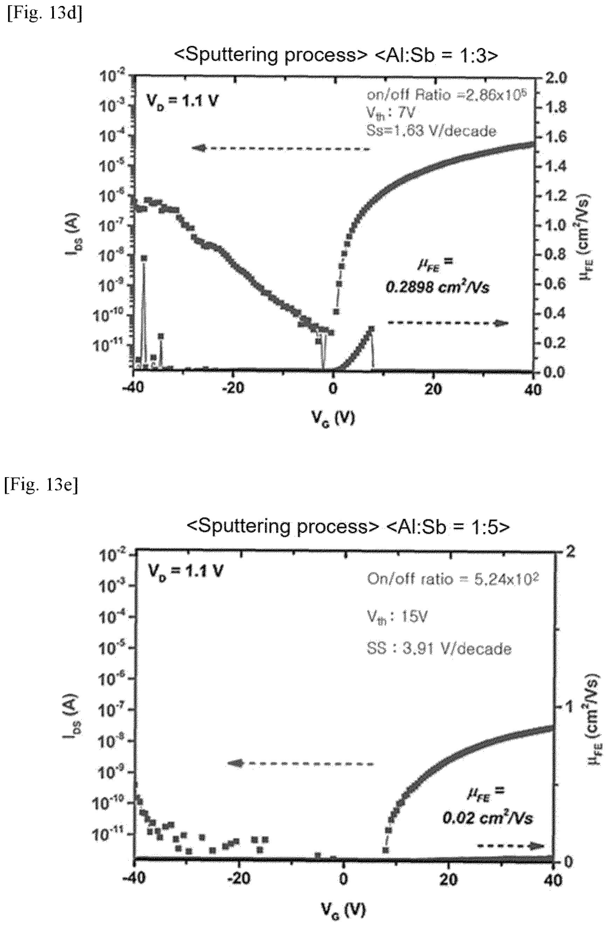

Figs. 13a to 13e show the test results of the oxide semiconductor devices manufactured by a deposition process with various molar ratios of Al:Sb. As a result of the test, the field effect mobility (µ_{FE}), on/off ratio, Vₜₕ, and SS changed depending on the molar ratio of Al:Sb. The highest µ_{FE} was shown when the molar ratio of Al:Sb was about 1:1.

### Example B2: Changes in the partial pressure ratio of argon:oxygen

The same procedure as in Example B was repeated to obtain an Al-Sb-O-based oxide semiconductor thin film, which was thermally treated at 400°C. In such an event, sputtering was carried out while the partial pressure ratio of Ar:O₂ was adjusted to 20:0.1, 20:0.5, and 20:1.0, respectively. Thereafter, an ITO electrode was deposited on the oxide semiconductor thin film to manufacture a thin film transistor (TFT), whose electrical characteristics were tested.

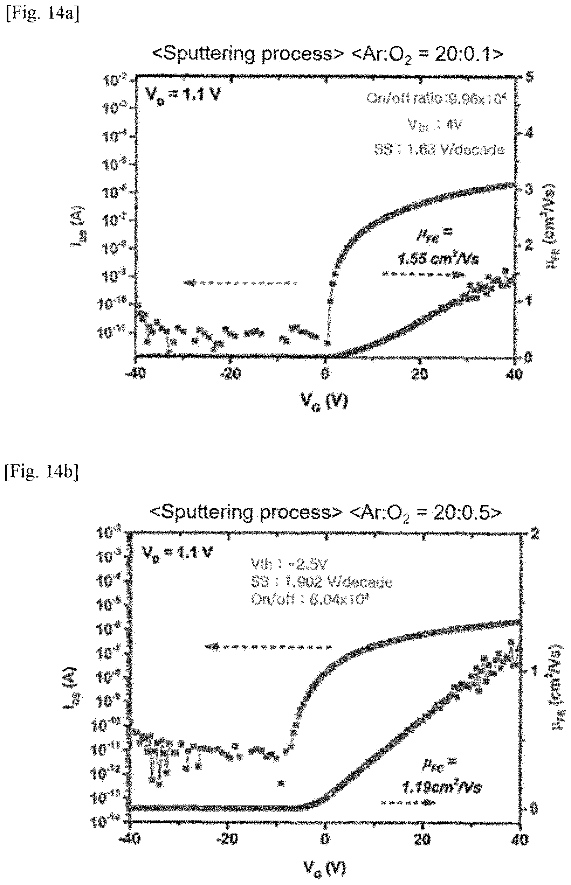

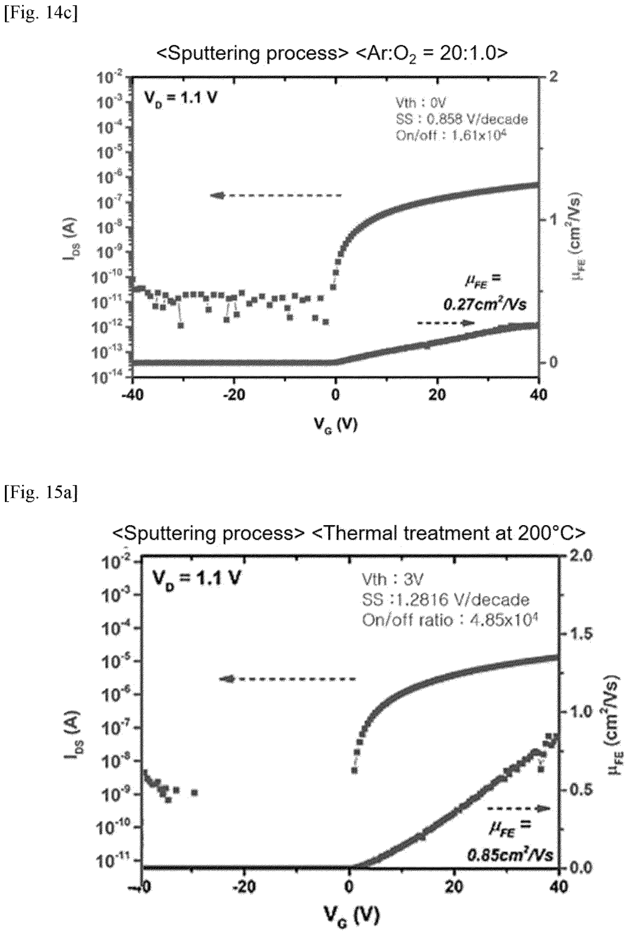

Figs. 14a to 14c show the test results of the oxide semiconductor devices manufactured by a deposition process with various partial pressure ratios of Ar:O₂. As a result of the test, the field effect mobility (µ_{FE}), on/off ratio, Vₜₕ, and SS changed depending on the partial pressure ratio of Ar:O₂. The highest µ_{FE} was shown when the partial pressure ratio of Ar:O₂ was about 20:1.

### Example B3: Changes in the thermal treatment temperature

The same procedure as in Example B was repeated, except that sputtering deposition was carried out for 1,000 seconds with the partial pressure ratio of Ar:O₂ set to 20:0.1 and the RF power set to 150 W for Al and 30 W for Sb to obtain an Al-Sb-O-based oxide semiconductor thin film with a thickness of 30 nm. The oxide semiconductor thin film thus obtained was thermally treated at a temperature of 200°C, 400°C, 600°C, or 800°C in an air atmosphere. Thereafter, an ITO electrode was deposited on the oxide semiconductor thin film to manufacture a thin film transistor (TFT), whose electrical characteristics were tested.

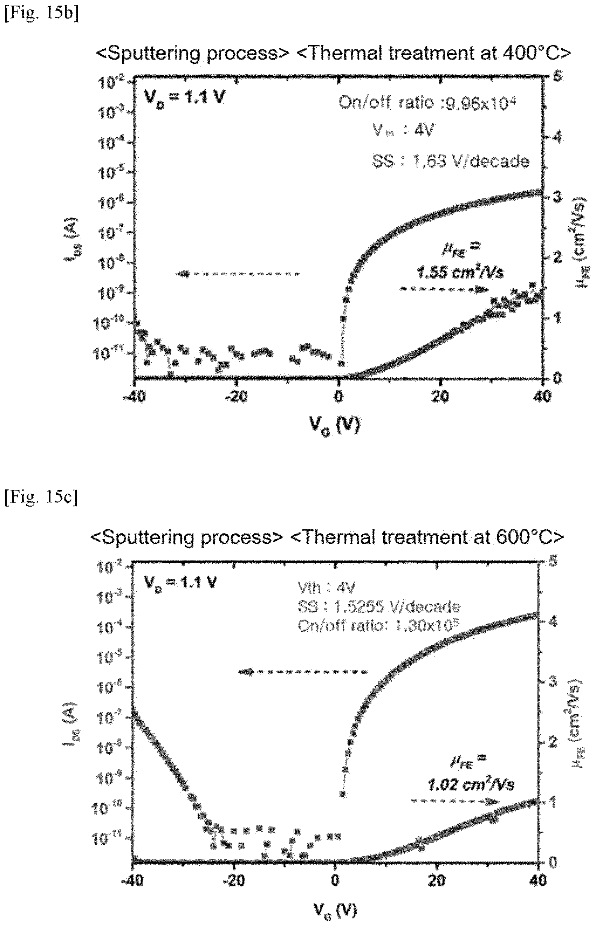

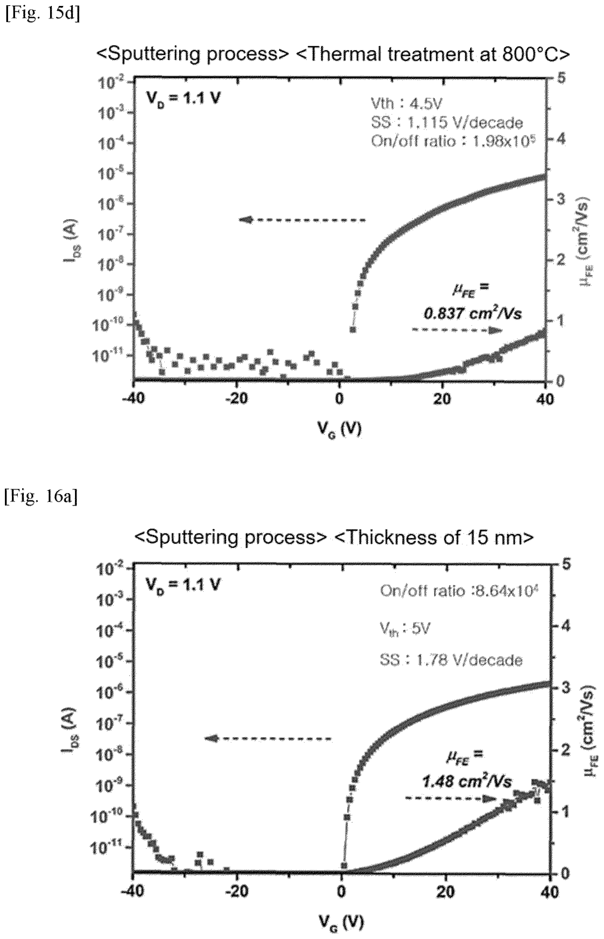

Figs. 15a to 15d show the test results of the oxide semiconductor devices thermally treated at various temperatures after the deposition process. As a result of the test, the field effect mobility (µ_{FE}), on/off ratio, Vₜₕ, and SS changed depending on the thermal treatment temperature. The highest µ_{FE} was shown when the thermal treatment temperature was about 400°C.

### Example B4: Changes in the thin film thickness

The same procedure as in Example B was repeated, except that sputtering deposition was carried out with the partial pressure ratio of Ar:O₂ set to 20:0.1 and the RF power set to 150 W for Al and 30 W for Sb to obtain an Al-Sb-O-based oxide semiconductor thin film.

In such an event, the thickness of the sputtering-deposited oxide semiconductor thin film was adjusted to 15 nm, 30 nm, or 45 nm.

Thereafter, an ITO electrode was deposited on the oxide semiconductor thin film to manufacture a thin film transistor (TFT), whose electrical characteristics were tested.

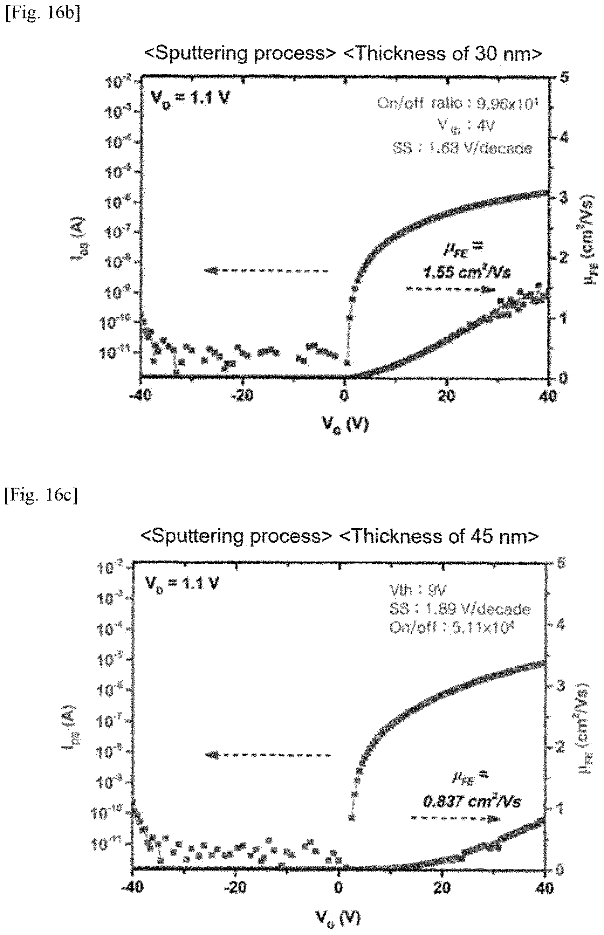

Figs. 16a to 16c show the test results of the oxide semiconductor devices manufactured with various thin film thicknesses through a deposition process. As a result of the test, the field effect mobility (µ_{FE}), on/off ratio, Vₜₕ, and SS changed depending on the thickness of the oxide semiconductor thin film. The highest µ_{FE} was shown when the thickness of the oxide semiconductor thin film was about 30 nm.

## Claims

1. An oxide semiconductor, which comprises an oxide containing aluminum (Al) and antimony (Sb).

2. The oxide semiconductor of claim 1, wherein the molar ratio of aluminum (Al) and antimony (Sb) in the oxide is 10:1 to 1:10.

3. The oxide semiconductor of claim 1, wherein the oxide is represented by the following Formula 1:
[Formula 1] AlₓSb_{y}O_{z}
in the above formula, 1 ≤ x ≤ 8, 1 ≤ y ≤ 8, and 1 ≤ z ≤ 15.

4. The oxide semiconductor of claim 1, wherein the oxide is at least one selected from the group consisting of AlSbO₄, AlSbO₃, Al₄Sb₂O₉, A1₂Sb₄O₁₃, Al₄Sb₂O₁₁, and Al₂Sb₄O₉.

5. The oxide semiconductor of claim 1, wherein the oxide semiconductor has an n-type electrical conductivity of 80 1/fQ/m/s or more and a band gap of 1.5 eV or more.

6. A method for manufacturing the oxide semiconductor of claim 1, which comprises:
mixing a first precursor solution containing an aluminum precursor and a second precursor solution containing an antimony precursor to prepare a sol-gel solution; and
coating the sol-gel solution on a substrate to form an oxide semiconductor thin film.

7. The method for manufacturing the oxide semiconductor according to claim 6, wherein the aluminum precursor is at least one selected from the group consisting of aluminum chloride, aluminum chloride hexahydrate, aluminum acetate, aluminum diacetate, aluminum acetylacetonate, aluminum sulfate hydrate, aluminum hydroxide hydrate, and aluminum isopropoxide; and
the antimony precursor is at least one selected from the group consisting of antimony chloride (III), antimony chloride (V), antimony acetate (III), antimony sulfide (III), antimony sulfide (V), antimony fluoride (III), antimony fluoride (V), and antimony ethoxide.

8. The method for manufacturing the oxide semiconductor according to claim 6, wherein the sol-gel solution comprises at least one solvent selected from the group consisting of acetonitrile, ethylene glycol, 2-methoxyethanol, ethanol, methanol, dimethylformamide, dimethyl sulfoxide, and deionized water.

9. The method for manufacturing the oxide semiconductor according to claim 6, wherein the concentration of the sol-gel solution is in the range of 0.05 M to 3 M.

10. The method for manufacturing the oxide semiconductor according to claim 6, wherein the sol-gel solution further comprises one or more additives selected from the group consisting of deionized water, hydrogen peroxide, monoethanolamine, and acetylacetone.

11. The method for manufacturing the oxide semiconductor according to claim 6, wherein the preparation of the sol-gel solution is carried out at 25°C to 140°C for 1 hour to 72 hours.

12. The method for manufacturing the oxide semiconductor according to claim 6, which further comprises thermal treatment after the coating, wherein the thermal treatment is carried out at a temperature of 150°C to 1,000°C for 30 minutes to 5 hours in an air or nitrogen atmosphere.

13. A method for manufacturing the oxide semiconductor of claim 1, which comprises sputtering-depositing an aluminum precursor and an antimony precursor on a substrate to form an oxide semiconductor thin film containing aluminum and antimony.

14. The method for manufacturing the oxide semiconductor according to claim 13, wherein the aluminum precursor comprises aluminum oxide, and the antimony precursor comprises antimony oxide.

15. The method for manufacturing the oxide semiconductor according to claim 13, wherein the sputtering deposition is carried out by injecting argon gas and oxygen gas, and the partial pressure ratio of argon gas and oxygen gas is in the range of 20:0.1 to 20:2.

16. The method for manufacturing the oxide semiconductor according to claim 13, which further comprises thermal treatment after the sputtering deposition, wherein the thermal treatment is carried out at a temperature of 150°C to 1,000°C for 30 minutes to 5 hours in an air or nitrogen atmosphere.

17. A semiconductor device, which comprises a substrate, a dielectric layer formed on the substrate, a semiconductor layer comprising the oxide semiconductor of claim 1 formed on the dielectric layer, and an electrode formed on the semiconductor layer.

18. The semiconductor device of claim 17, wherein the thickness of the semiconductor layer is 5 nm to 50 nm.

19. A thin film transistor, which comprises the semiconductor device of claim 17.

20. A display device, which comprises the thin film transistor of claim 19.
